# EUROPÄISCHE PATENTSCHRIFT

(11) **EP 1 665 920 B1**
(45) Veröffentlichungstag und Bekanntmachung des Hinweises auf die Patenterteilung: **28.11.2007**
(21) Anmeldenummer: 04766526.0
(22) Anmeldetag: 18.08.2004
(51) Int. Cl.: H05K 13/04

(54) **VORRICHTUNG ZUM BESTÜCKEN VON SUBSTRATEN MIT ELEKTRISCHEN BAUELEMENTEN**
DEVICE FOR FITTING SUBSTRATES WITH ELECTRICAL COMPONENTS
DISPOSITIF POUR IMPLANTER DES COMPOSANTS ELECTRIQUES SUR DES SUBSTRATS

(30) Priorität: 23.09.2003 DE 10344068
(43) Veröffentlichungstag der Anmeldung: 07.06.2006
(73) Patentinhaber: SIEMENS AKTIENGESELLSCHAFT, 80333 München (DE)
(72) Erfinder: STANZL, Harald, 81476 München (DE); MEHDIANPOUR, Mohammad, 81829 München (DE); FRINDT, Matthias, 80798 München (DE)
(86) Internationale Anmeldenummer: PCT/EP2004/051825
(87) Internationale Veröffentlichungsnummer: WO 2005/032233

(56) Entgegenhaltungen:
- EP-A- 0 971 390
- US-A- 5 033 783
- US-A- 5 839 187
- PATENT ABSTRACTS OF JAPAN Bd. 011, Nr. 123 (M-581), 17. April 1987 (1987-04-17) & JP 61 265232 A (MATSUSHITA ELECTRIC IND CO LTD), 25. November 1986 (1986-11-25)

## Beschreibung

Die Erfindung bezieht sich auf eine Vorrichtung zum Bestücken von Substraten mit elektrischen Bauelementen gemäß dem Oberbegriff des Anspruchs 1.

Eine derartige Vorrichtung ist aus der Patentschrift US-5033783 bekannt. Durch die EP 0971390 A ist eine Bestückvorrichtung bekannt geworden, bei der ein Bestückkopf zwischen zwei fest vorgegebenen Orten parallel zu einem Substrat linear verfahrbar ist, das auf einem getakteten Bandtransport geführt ist. Neben dem Bandtransport befindet sich ein x-y-verschiebbarer Wafertisch, auf dem Bauelemente in einem zum Substrat parallelen Wafer bereitgestellt werden. Dabei kann jeweils eines der Bauelemente vom Bestückkopf erfasst, über das seitlich verschiebbare Substrat verfahren und auf dieses aufgesetzt werden. Da der Wafertisch nur einen begrenzten x-y-Verschiebebbereich aufweist, ist es nicht möglich alle Bauelemente des Wafers an den Abholort des Bestückkopfes zu bringen. Der Wafer ist jedoch auf einem Drehteller gelagert, der um 90° oder 180° verdreht werden kann, um auch die restlichen Bauelemente abzuholen. Ein solche unflexible Vorrichtung eignet sich nur für die Verarbeitung eins einzigen Bauelementetyps. Zur Herstellung komplexer Schaltungen werden weitere Bauelemente benötigt, die in einer weiteren Vorrichtung bestückt werden müssen.

Der Erfindung liegt die Aufgabe zugrunde, eine Vorrichtung zu schaffen, mit der die Substrate mit einer größeren Vielfalt an Bauelementen bestückt werden können und eine möglichst große Anzahl an Bauelemente-Zuführeinrichtungen im Zugriffsbereich des Bestückkopfes angeordnet werden kann.

Diese Aufgabe wird durch die Erfindung gemäß Anspruch 1 gelöst. Durch die Verwendung eines 2-dimensional verfahrbaren Bestückkopfes wird nur ein Positioniersystem sowohl für den Abholbereich wie auch für den Bestückbereich benötigt ohne dass das Substrat oder die Zuführeinrichtungen für die Bauelemente bewegt werden müssen. Die Positioniergenauigkeit des weiträumig verfahrbaren Bestückkopfes ist den feinen Strukturen eines Wafer-Bauelementes angepasst, was durch besondere Maßnahmen beim Aufbau und der Ausgestaltung der Vorrichtung erreicht wird.

Der Verfahrbereich des Bestückkopfes kann so groß gehalten werden, dass er nicht nur einen Teilbereich der Waferfläche, sondern auch die Abholstellen weiterer Bauelementezuführungen überdeckt. Dadurch ist es, möglich komplexe Schaltungen auf den Substraten herzustellen. Ferner wird zusätzlicher Raum für die Aufstellung weiterer Bauelementezuführungen geschaffen.

Vorteilhafte Weiterbildungen der Erfindung sind in den Ansprüchen 2 bis 3 gekennzeichnet.

Durch die Weiterbildung nach Anspruch 2 werden die Außenabmessungen der Vorrichtung klein gehalten.

Durch die Weiterbildung nach Anspruch 3 kann der Wafertisch durch übliche Bauelementezuführungen ersetzt werden, so dass die Vorrichtung auch als einfache Bestückvorrichtung genutzt werden kann.

Im Folgenden wird die Erfindung anhand eines in der Zeichnung dargestellten Ausführungsbeispieles näher erläutert. Es zeigen:
- Figur 1: eine Seitenansicht einer Bestückvorrichtung gemäß der Erfindung,
- Figur 2: einen Schnitt entlang der Linie II-II in Figur 1

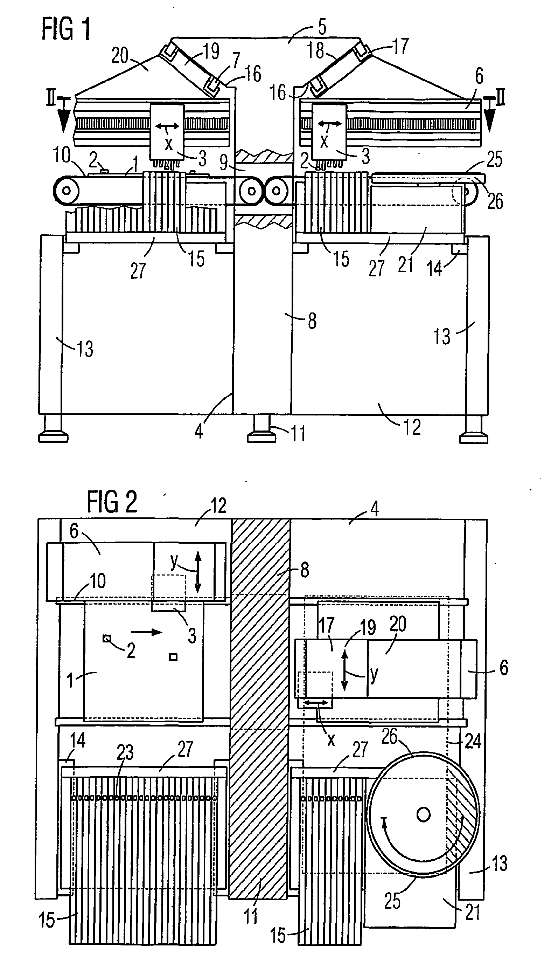

Die Figuren 1 und 2 zeigen eine Vorrichtung zum Bestücken von flachen Substraten 1 mit elektrischen Bauelementen 2 mittels eines in einer Arbeitsebene parallel zum Substrat 1 verfahrbaren Bestückkopfes 3. Ein Chassis 4 der Vorrichtung weist einen stationären Träger 5 auf, an dem ein Positionierarm 6 in einer Koordinatenrichtung Y verschiebbar geführt ist. Der Bestückkopf 3 ist am länglichen Positionierarm 6 in einer zu Koordinatenrichtung y senkrechten Koordinatenrichtung x verschiebbar geführt. Der Träger ist oberhalb des Positionierarms 6 angeordnet und überdeckt in der Querrichtung einen Teil des Positionierarms 6 und weist in diesem Bereich Längsführungselemente 7 für den Positionierarm 6 auf. Von dort aus erstreckt sich der Träger 5 in der Querrichtung bis über eines der Stirnenden des Positionierarms 6 und ist dort mit einer nach unten weisenden, sich in der Längsrichtung erstreckenden starren Tragwand 8 über seine gesamte Länge fest verbunden

Die Tragwand 8 ist in ihrem mittleren Bereich mit einem Durchbruch 9 versehen, durch den eine Transportstrecke 10 für die Substrate 1 senkrecht hindurch geführt ist. Die gesamte Vorrichtung ist zu beiden Seiten der Tragwand 8 spiegelsymmetrisch aufgebaut mit dem nach beiden Seiten auskragenden Träger 5, der Längsführungen 7, den Positionierarmen 6 und Bestückköpfen 3. Die Substrate 1 können dementsprechend auf der Transportstrecke an Bestückplätzen zu beiden Seiten der Tragwand 8 temporär fixiert werden.

Die Tragwand 8 ist an ihrer Unterseite mit Stützfüßen 11 versehen und entlastet. Das Chassis 4 weist ferner unterhalb der Transportstrecke einen quer zur Tragwand 8 orientierten rohrartigen Stützkörper 12 auf, der sich quer zur Tragwand 8 erstreckt und an dessen Außenseiten seitliche Stützwände 13 angesetzt sind, die mit Auflagestegen 14 für schmale, nebeneinanderliegende Bauelementezuführungen 15 versehen sind. Diese weisen eine Reihe von Abholplätze 23 auf, an denen die z.B. aus Spulen zugeführten Bauelemente 2 durch den Bestückkopf 3 entnommen werden können, der dann diese Bauelemente 2 zu ihren Montageplätzen auf dem Substrat 1 transportiert.

Die Längsführungselemente 7 für den Positionierarm 6 sind an einer äußeren Längsseite 16 des Trägers 5 angeordnet. Diese Längsseite 16 ist schräg zur Arbeitsebene geneigt und die entsprechende Führungsseite des Positionierarms ist in ihrer Neigung der Längsseite 16 angepasst. Die Längsführungselemente 7 sind in zwei Spuren angeordnet und bilden eine Führungsebene, die parallel zur Längsseite 16 verläuft. Längsführungsteile 17 des Positionierarmes 6 greifen in die Längsführungselemente 7 ein.

Der Positionierarm 6 ist mittels eines Linearmotors angetrieben, wobei entlang der äußeren Längsseite 16 des Trägers 4 angebrachte Magnetteile 18 stationäre Antriebsteile bilden. Ein dem Positionierarm zugeordnetes mobiles Spulenteil 19 ist zwischen den Längsführungsteilen 17 des Positionierarms 6 angeordnet und bildet die mobilen Antriebsteile. Eine Trennebene zwischen den stationären und mobilen Teilen des Linearmotors ist der schrägen Längsseite 16 des Trägers 5 angenähert.

Die Längsseite 16 ist an einer freien Vorderseite des Trägers 5 angeordnet und nach hinten und unten schräg stehend ausgebildet, wodurch eine gute Zugänglichkeit zu den Funktionsräumen der Vorrichtung zum Beispiel für Wartungszwecke erreicht wird. Der Positionierarm 6 ist über ein integrales dachartiges Koppelteil 20 mit den Längsführungsteilen 17 verbunden. Die schräg stehenden Wände des Koppelteils 20 reichen bis in die Nähe von Stirnenden des Positionierarmes 6, der dadurch entsprechend verstärkt wird.

Insbesondere wird durch die Schrägstellung ein günstiger Verlauf der Kraftlinien zwischen dem Positionierarm und der Tragwand 8 erreicht, so dass die beim Bestücken auftretenden Massenkräfte besonders wirksam in das Chassis 4 übergeleitet werden können.

Ähnlich wie der Träger 6 weist auch der Positionierarm 6 für den Bestückkopf 3 eine schrägstehende Führungsseite auf, die an einer schrägen Längswand 22 ausgebildet ist. Im abgeschrägten Bereich des Bestückkopfes steht ein Bauraum zur Verfügung, in dem verschiedene Komponenten des Bestückkopfes 3 raumsparend untergebracht sein können, wodurch insbesondere die Baubreite des Positionierarms mit dem Bestückkopf klein gehalten werden kann.

Ein durch die strichpunktierten Linien markierter maximaler Zugriffsbereich 24 des Bestückkopfes 3 überdeckt den Bestückbereich des Substrats 1 und den Abholbereich der Bauelemente 2 mit den Abholplätzen 23. Auf einer Seite der Tragwand 8 ist ein Teil der Bauelementezuführungen 15 durch einen Wafertisch 21 ersetzt, bei dem ein zum Substrat paralleler Wafer 25 auf einem Drehteller 26 aufliegt, der mit einer zum Wafer senkrechten Drehachse versehen ist. Die Längsführungen 7 sind so weit verlängert, das der Zugriffsbereich 24 in der Koordinatenrichtung y erheblich über die Abholstellen 23 hinaus vergrößert ist und in dieser Richtung den Wafer 25 vollständig überdeckt. Dadurch ist es ohne ein Verschieben des Wafertisches möglich, sämtliche Bauelemente des Wafers mit dem Bestückkopf zu erreichen.

Der Wafertisch 21 ist in der Koordinatenrichtung x soweit in eine Randzone des Zugriffsbereiches 24 verlagert, dass ein Teil des Wafers 25 aus dem Zugriffsbereich 20 heraus bis über die seitliche Stützwand 13 ragt, die im Hinblick auf die Bestückvorgänge einen Totraum der Vorrichtung darstellt. Dieser schraffierte Bereich kann durch Verdrehen des Drehtellers um 180° gemäß dem dargestellten Drehpfeil in den Zugriffsbereich 24 gebracht und entleert werden. Durch die seitliche Verlagerung des Wafers über den Zugriffsbereich hinaus ist es möglich, zusätzliche Bauelementezuführungen 15 für zusätzliche Bauelemente anzuordnen, wodurch das Spektrum an unterschiedlichen Bauelementetypen entsprechend erweitert wird. Würde die Länge des Zugriffsbereichs 24 in der y-Richtung z.B. bis zu Drehachse des Drehtellers 26 verkürzt werden, so könnten die weiteren unzugänglichen Bereiche Wafers 25 durch verkleinerte Winkelschritte von z. B. 90° in den entsprechend verkleinerten zugänglichen Sektor des Wafers 25 verdreht werden.

Ein Zuführtisch 27, auf dem die Bauelementezuführungen 15 und der Wafertisch 21 fixiert sind, ist im Bereich des Wafertisches 21 so ausgebildet, dass auch an dieser Stelle anstelle des Wafertisches 21 weitere Bauelementezuführungen 15 fixiert werden können, was die Vielzahl der Bauelementetypen erhöht. Es versteht sich, das auch auf dem anderen Zuführtisch 27 anstelle einiger der Bauelementezuführungen 15 ein weiterer Wafertisch 21 vorgesehen werden kann, so dass das Substrat 1 mit einem weiteren Waferbauelement bestückt werden kann.

### Bezugszeichen

- x, y: Koordinatenrichtung
- 1: Substrat
- 2: Bauelement
- 3: Bestückkopf
- 4: Chassis
- 5: Träger
- 6: Positionierarm
- 7: Längsführungselement
- 8: Tragwand
- 9: Durchbruch
- 10: Transportstrecke
- 11: Stützfuß
- 12: Stützkörper
- 13: Stützwand
- 14: Auflagesteg
- 15: Bauelementezuführung
- 16: Längsseite
- 17: Längsführungsteil
- 18: Magnetteil
- 19: Spulenteil
- 20: Koppelteil
- 21: Wafertisch
- 22: Längswand
- 23: Abholplatz
- 24: Zugriffsbereich
- 25: Wafer
- 26: Drehteller
- 27: Zuführtisch

## Patentansprüche

1. Vorrichtung zum Bestücken von Substraten (1) mit elektrischen Bauelementen (2) mittels eines in zwei Koordinatenrichtungen (x, y) parallel zum Substrat (1) verschiebbaren Bestückkopfes (3), wobei mehrere Stellplätze für verschiedene Bauelementzuführungen (25) im Zugriffsbereich (24) des Bestückkopfs (3) vorgesehen sind,
**dadurch gekennzeichnet, dass**
- zumindest eine Teilmenge der Bauelemente (2) in Form eines Wafers (25) auf einem zum Substrat (1) parallelen Wafertisch (21) bereitstellbar ist, der zumindest partiell im Zugriffsbereich (24) des Bestückkopfes (3) liegt,
- der Wafertisch (21) derart in einer Randzone des Zugriffsbereichs (24) des Bestückkopfs (3) angeordnet ist, dass ein Teilbereich des Wafers (25) außerhalb des Zugriffsbereichs (24) liegt, und
- der Wafertisch (21) einen Drehteller (26) zur Aufnahme des Wafers (25) mit einer zum Wafer (25) senkrechten Drehachse aufweist.

2. Vorrichtung nach Anspruch 1,
**dadurch gekennzeichnet, dass** der unzugängliche Bereich des Wafers (25)in Toträume der Vorrichtung ragt.

3. Vorrichtung nach Anspruch 1,
**dadurch gekennzeichnet, dass** der vom Wafertisch (21) belegte Stellplatz für die optionale Anordnung von weiteren Bauelementezuführungen (15) ausgestattet ist.

## Claims

1. Device for fitting substrates (1) with electrical components (2) by means of a fitting head (3) that can be displaced parallel to the substrate (1) in two coordinate directions (x, y), a plurality of placement locations for different component feeders (25) being provided in the access range (24) of the fitting head (3),
**characterized in that**
- at least a subset of the components (2) can be provided in the form of a wafer (25) on a wafer table (21) which is parallel to the substrate (1) and which is located at least partially in the access range (24) of the fitting head (3),
- the wafer table (21) is arranged in an edge zone of the access range (24) of the fitting head (3) in such a way that a subregion of the wafer (25) lies outside the access range (24), and
- the wafer table (21) has a turntable (26) to accommodate the wafer (25) with an axis of rotation at right angles to the wafer (25).

2. Device according to Claim 1, **characterized in that** the inaccessible region of the wafer (25) projects into a dead space of the device.

3. Device according to Claim 1, **characterized in that** the placement location occupied by the wafer table (21) is equipped for the optional arrangement of further component feeders (15).

## Revendications

1. Dispositif pour implanter des composants (2) électriques sur des substrats (1) au moyen d'une tête (3) d'implantation pouvant coulisser parallèlement au substrat (1) dans deux directions (x, y) de coordonnées, plusieurs emplacements pour diverses amenées (25) de composants étant prévus dans la partie (24) d'accès de la tête (3) d'implantation,
**caractérisé en ce que**
- au moins une quantité partielle des composants (2) peut être mise à disposition sous la forme d'une tranche (25) sur une table (21) de tranche parallèle au substrat (1) et se trouvant au moins partiellement dans la partie (24) d'accès de la tête (3) d'implantation ;
- la table (21) de tranche est disposée dans une zone marginale de la partie (24) d'accès de la tête (3) d'implantation de façon à ce qu'une sous-partie de la tranche (25) se trouve à l'extérieur de la partie (24) ; et
- la table (21) de tranche a un plateau (26) tournant de réception de la tranche (25) ayant un axe de rotation perpendiculaire à la tranche (25).

2. Dispositif suivant la revendication 1,
**caractérisé en ce que** la partie inaccessible de la tranche (25) fait saillie dans des espaces morts du dispositif.

3. Dispositif suivant la revendication 1,
**caractérisé en ce que** l'emplacement occupé par la table (21) de tranche est équipé pour l'agencement éventuel d'autres amenées (15) de composants.
